# EUROPEAN PATENT APPLICATION

(11) **EP 4 167 697 A1**
(43) Date of publication of application: **19.04.2023**
(21) Application number: 21202268.5
(22) Date of filing: 12.10.2021
(51) Int. Cl.: H05K 7/20

(54) **COOLING DEVICE FOR OPTICAL AND/OR ELECTRONIC ELEMENTS**

(71) Applicant: TOMRA Sorting GmbH, 56218 Mülheim-Kärlich (DE)
(72) Inventor: BALTHASAR, Dirk, 56154 BOPPARD (DE); NOACK, Nils, 56237 NAUORT (DE); BRINKMANN, Nils, 56410 MONTABAUR (DE); WALDORF, Michael, 56132 BECHELN (DE)
(74) Representative: AWA Sweden AB

(57) **Abstract**

The present invention relates to a cooling device (1) for optical and/or electronic elements (4) of an apparatus (2), comprising; at least one vortex tube (7) for generating cold air; at least one air-to-air heat exchanger (11; 11') comprising at least one closed heat exchanger channel (14; 14'); the air-to-air heat exchanger (11; 11') further comprising a heat exchanger inlet (13) for receiving the cold air and guiding it into the at least one closed heat exchanger channel (11; 11'), and a heat exchanger outlet (15) for exhausting air from the at least one closed heat exchanger channel (14; 14').

## Description

### FIELD OF THE INVENTION

The present invention relates to a cooling device, and more specifically to a cooling device comprising a vortex tube and an air-to-air heat exchanger.

### BACKGROUND

Cooling of elements in an apparatus is an important aspect in various industrial applications. Sufficient cooling is key for an apparatus comprising elements that are easily affected by heat, or that are affected by high temperatures. Heat may be generated from the apparatus itself, or come from the ambient environment.

Optical and electric elements of sorters is one example of elements that are sensitive to excess heat. It is key that the optical elements of a sorter is not contaminated in any way, such that the sorter can function accurately without interference. The temperature of optical elements needs to be controlled below a certain threshold for an optical system to perform correctly, as e.g. alignment may be corrupted due to thermal expansion. Too high temperatures may e.g. cause displacement of the optical elements, drift of gratings, increased noise level in detectors, melt downs of photodiodes etc. The temperature of electric components must also be controlled e.g. in order to reduce noise, prevent melt-down, ensure optimal function and prevent power-off due to preset temperature levels for preventing overheating.

At the most extreme locations, the ambient temperature may be up to 65°C, and as such, a commercially viable solution is required for cooling of optical and/or electric elements of an apparatus..

Designing optical systems for industrial applications running at elevated temperatures can be challenging to ensure optimal performance and accuracy. The cooling of such optical systems may be achieved using cooled air or water running through a supporting jacket. In particular in the space limitation within vision sorters, cooling over 50°C ambient temperature is difficult since no back chillers are available for water coolers.

Vortex cooling is a valid cooling option in environments above 50°C due to the high degree of efficiency. A vortex tube, also known as a Ranque-Hilsch vortex tube, is a mechanical device that is powered by compressed air, and that separates a compressed gas into hot and cold streams. The gas emerging from the hot end of a vortex tube can reach temperatures of 200°C, and the gas emerging from the cold end can reach -50°C.

Air that rotates around an axis is called a vortex. A vortex tube creates cold air and hot air by forcing compressed air through a generation chamber, which spins the air at a high rate of speed (1,000,000 rpm) into a vortex. The high speed air heats up as it spins along the inner walls of the tube toward a control valve. A percentage of the hot, high speed air is permitted to exit at the valve. The remainder of the (slower) air stream is forced to counterflow up through the center of the high speed air stream in a second vortex. The slower moving air gives up energy in the form of heat and becomes cooled as it spins up the tube. The inside counterflow vortex exits the opposite end as extremely cold air.

Vortex tubes may generate temperatures as much as 56°C below the inlet air temperature. The fraction of hot air exhausted can be varied to change the outlet cold air temperature, with more exhaust resulting in a colder cold air stream with lower flow rate, and less exhaust resulting in a warmer cold air stream with higher flow rate.

Unfortunately, vortex coolers exhaust cold air that might be contaminated by impurities like oil, and this air is as such not suited for cooling of optical elements and the like. Air filters may be installed to reduce or alleviate the problem of contamination, however, air filters commonly require pedantic recurring maintenance which does not create a commercially viable solution for e.g. vision sorters.

Existing cooling devices are also commonly purpose built for a specific application and are not designed to be easily retrofitted to existing applications.

Documents useful for understanding the field of technology include US10113734B2, EP2839724B1, WO2020261897A1 and US6840628B2.

### SUMMARY OF THE INVENTION

In view of that stated above, an object of the present invention is to provide a cooling device that is suitable for use in high ambient temperatures (temperatures above 50°C) and that provides clean, cooled air.

Another object is to provide such a cooling device that can easily be retrofitted to existing apparatuses, optionally in addition to an already existing cooling which existing cooling may be kept as it is, removed or modified.

Another object is to provide such a cooling device that does not require an air filter and needs minimal maintenance.

To achieve at least one of the above objects, and also other objects that will be evident from the following description, a cooling device having the features defined in claim 1 is provided according to the present invention. Preferred variants of the apparatus will be evident from the dependent claims.

According to a first aspect, there is provided a cooling device for optical and/or electronic elements of an apparatus. The cooling device comprises at least one vortex tube for generating cold air, at least one air-to-air heat exchanger comprising at least one closed heat exchanger channel. The air-to-air heat exchanger further comprises a heat exchanger inlet for receiving the cold air and guiding it into the at least one closed heat exchanger channel, and a heat exchanger outlet for exhausting air from the at least one closed heat exchanger channel.

The vortex tube operates independently of ambient temperatures, and generates a hot air stream and a cold air stream. As the cold air stream is led into the closed heat exchanger channel through the heat exchanger inlet, the air-to-air heat exchanger is cooled down and may effectively cool optical and/or electronic elements of an apparatus. The hot air stream is not led into the closed heat exchanger channel, but is advantageously led away from the air-to-air heat exchanger. As the cold air passes through a closed heat exchanger channel, the cold air does not mix with the air surrounding the air-to-air heat exchanger and potential contamination of the surrounding air is avoided.

According to an embodiment, if the closed heat exchanger channel is oriented such that the heat exchanger outlet is at or below the lowest point of the closed heat exchanger channel, the heat exchanger inlet is at or above the highest point of the closed heat exchanger channel, such that impurities and contaminations of the cold air is forced out through the outlet due to gravity and the pressure of the cold air.

According to an embodiment, the at least one closed heat exchanger channel comprises a plurality of cooling ribs for increasing the outer surface area of the air-to-air heat exchanger.

According to an embodiment, the heat exchanger inlet is provided on an inlet manifold and the heat exchanger outlet is provided on an outlet manifold and the at least one closed heat exchanger channel comprises a plurality of tubes for flowing the cold air from the inlet manifold to the outlet manifold.

According to an embodiment, the plurality of tubes are U-shaped and arranged side-by-side with an airgap between each tube for allowing a flow of air past each tube to increase the cooling efficiency.

According to an embodiment, the inlet manifold is provided at a first distal end of the plurality of closed heat exchanger channels and the outlet manifold is provided at a second distal end of the plurality of closed heat exchanger channels.

According to an embodiment, the cooling device further comprises at least one fan for increasing the efficiency of the air-to-air heat exchanger.

According to an embodiment, the at least one fan is provided adjacent the inlet manifold and the outlet manifold, for circulating air past the plurality of closed heat exchanger channels.

According to an embodiment, a wall panel is provided between the at least one vortex tube and the at least one air-to-air heat exchanger, and an inlet connection allows cold air from the at least one vortex tube to flow through the wall panel to the at least one air-to-air heat exchanger.

According to an embodiment, the wall panel comprises a recess for accommodating the at least one air-to-air heat exchanger.

According to a second aspect, an apparatus comprises optical and/or electronic elements housed in a cabinet, and at least one cooling device according to embodiments of the present invention, for cooling the optical and/or electric elements. The air-to-air heat exchanger of the at least one cooling device is arranged inside the cabinet and the heat exchanger outlet is arranged to exhaust air from the at least one closed heat exchanger channel to the outside of the cabinet.

As the cold air of the air-to-air heat exchanger passes the closed heat exchanger channel, it does not mix with the air surrounding the air-to-air heat exchanger, and potential contamination of the surrounding air is avoided. The cold air escapes the closed heat exchanger channel through the heat exchanger outlet and is exhausted outside the cabinet. Optical and/or electronic elements housed inside the same cabinet as the air-to-air heat exchanger are therefore cooled down without the risk of contamination form the cold air.

According to an embodiment, the vortex tube hot end of the at least one vortex tube is arranged on the outside of the cabinet.

According to an embodiment, the at least one vortex tube is arranged on the outside of the cabinet and connected to a device for providing pressurized air.

According to an embodiment, the apparatus is a vision sorting apparatus and the optical and/or electric elements preferably comprises a machine vision system and/or an imaging spectroscopy system.

According to an embodiment, the apparatus additionally comprises a primary cooling system and the at least one cooling device is activated at a predetermined temperature threshold.

A further scope of applicability of the present invention will become apparent from the detailed description given below. However, it should be understood that the detailed description and specific examples, while indicating preferred variants of the present inventive concept, are given by way of illustration only, since various changes and modifications within the scope of the inventive concept will become apparent to those skilled in the art from this detailed description.

Hence, it is to be understood that this inventive concept is not limited to the particular component parts of the device described as such device may vary. It is also to be understood that the terminology used herein is for purpose of describing particular variants only, and is not intended to be limiting. It must be noted that, as used in the specification and the appended claim, the articles "a," "an," "the," and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings does not exclude other elements.

### BRIEF DESCRIPTION OF THE DRAWINGS

The aspects of the present inventive concept, including its particular features and advantages, will be readily understood from the following detailed description and the accompanying drawings. The figures are provided to illustrate the general structures of the present inventive concept. Like reference numerals refer to like elements throughout.
Fig. 1 shows a schematic side view of an apparatus comprising a cooling device.
Fig. 2 shows a perspective view of a first embodiment of a cooling device mounted on an apparatus.
Fig. 3a shows a top view of the first embodiment of a cooling device.
Fig. 3b shows a side view of the first embodiment of a cooling device.
Fig. 4 shows a perspective view of a first embodiment of an air-to-air heat exchanger.
Fig. 5 shows a perspective view of a first embodiment of a heat exchanger channel.
Fig. 6 shows a perspective view of a second embodiment of an air-to-air heat exchanger.
Fig. 7 shows a schematic side view of the second embodiment of an air-to-air heat exchanger.
Fig. 8 shows a perspective view of a third embodiment of an air-to-air heat exchanger.

### DETAILED DESCRIPTION

The present inventive concept will now be described more fully hereinafter with reference to the accompanying drawings, in which currently preferred variants of the inventive concept are shown. This inventive concept may, however, be implemented in many different forms and should not be construed as limited to the variants set forth herein; rather, these variants are provided for thoroughness and completeness, and fully convey the scope of the present inventive concept to the skilled person.

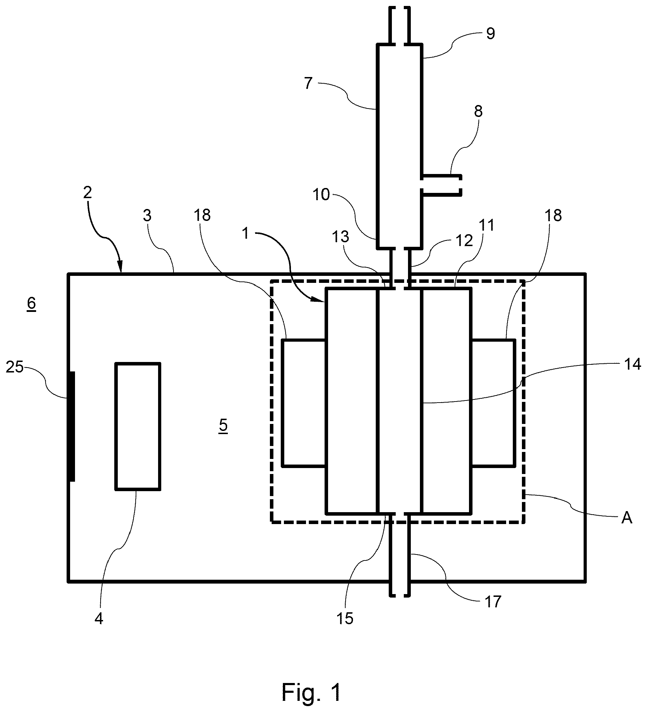

Figure 1 shows a schematic side view of a cooling device 1 arranged in an apparatus 2. The apparatus 2 comprises a cabinet 3 with optical and/or electronic elements 4 arranged on the inside 5. The inside 5 of the cabinet 3 may be a clean environment and is shielded from the outside 6. The apparatus 2 may as such be a vision sorting apparatus, and the optical and/or electronic elements 4 may be arranged at different locations inside the apparatus 2. The optical and/or electronic elements 4 may be lenses, mirrors, glass windows, lasers, illumination, electromagnetic sources, detectors, scanners or any means for e.g. identifying objects outside or in the vicinity of the apparatus 2. The cabinet 3 may as such comprise a window 25 through which optical elements on the inside 5 interact with objects on the outside 6. Preferably, the optical and/or electronic elements 4 may comprise illumination source and/or an optical radiation detection device, such as a camera and/or a spectrometer where the camera and/or spectrometer may comprise a line or matrix detector. According to one embodiment, optical and/or electronic elements are part of or forms a machine vision system and/or an imaging spectroscopy systems.

The outside 6 of the apparatus 2 may be dusty and warm ambient air. The ambient temperature on the outside 6 may as such exceed 50°C, and may in periods exceed 65°C. If the ambient temperature is very high, or expected to be very high, the cabinet 3 may preferably be insulated, in order to prevent the temperature on the inside 5 from being affected by the temperature on the outside 6.

The cooling device comprises a vortex tube 7, and the illustrated embodiment comprises one vortex tube 7. The cooling device 1 may as such comprise a plurality of vortex tubes 7, in order to increase the cooling capacity. A vortex tube 7 is a well-known device for generating very cold air, as described in the background section. The vortex tube 7 comprises a gas inlet 8 through which it is fed pressurized gas such as compressed air. The vortex tube 7 converts the compressed air into a hot air stream and a cold air stream. The vortex tube 7 comprises a hot end 9 from which hot air is exhausted, and a cold end 10 from which cold air is exhausted. The hot air stream may be exhausted directly to the outside 6, or may advantageously be led further away from the vortex tube 7 and apparatus 2 in order to prevent the hot air from affecting the temperature on the inside 5.

In the illustrated embodiment, the vortex tube 7 is arranged on the outside 6 of the cabinet 3 of the apparatus 2. Both the hot end 9 and the cold end 10 of the vortex tube 7 of the illustrated embodiment are thus arranged outside the cabinet 3. In alternative embodiments, the vortex tube 7 may be partially or fully housed inside the cabinet 3. However, the hot end 9 should be connected to the outside 6, such that the hot air stream from the vortex tube 7 is exhausted outside the cabinet 3. The hot end 9 and alternatively connection means for connecting the hot end 9 to the outside 6 should in this embodiment be isolated, in order to avoid heat radiating from the hot end 9 from affecting the temperature on the inside 5. In this alternative embodiment, a heat brake may also be provided between the cabinet 3 and the hot end 9 of the vortex tube 7.

The cold end 10 of the vortex tube 7 is connected to an air-to-air heat exchanger 11 at an heat exchanger inlet 13. The components of the air-to-air heat exchanger 11 are indicated inside a stapled box A in figure 1. An inlet connection 12 may connect the cold end 10 of the vortex tube 7 the air-to-air heat exchanger 11, and more specifically to a closed heat exchanger channel 14 of the air-to-air heat exchanger 11. Cold air from the vortex tube 7 is as such fed to the air-to-air heat exchanger 11. The inlet connection 12 may be a rigid tube, a flexible hose, a valve, or any connection means for connecting the vortex tube 7 to the air-to-air heat exchanger 11. The inlet connection 12 may preferably be isolated or made from a material with low heat conductivity, in order to minimize heat loss. The inlet connection 12 is optional, as the cold end 10 of the vortex tube 7 may be connected directly to the heat exchanger inlet 13.

The air-to-air heat exchanger 11 is in the illustrated embodiment located on the inside 5 of the apparatus 2. The air-to-air heat exchanger 11 may preferably not be exposed to the outside 6, and the cabinet 3 may separate the vortex tube 7 and the air-to-air heat exchanger 11 of the cooling device 1. More preferably, the air-to-air heat exchanger 11 may have no thermal conductive contact with the cabinet 3, in order to avoid heat loss. The air-to-air heat exchanger 11 may as such arranged a distance from the cabinet 3. Alternatively, or additionally, the air-to-air heat exchanger 11 may be isolated from the cabinet 3 or only contact the cabinet 3 by elements with low thermal conductivity.

The air-to-air heat exchanger 11 comprises at least one closed heat exchanger channel 14, and the heat exchanger inlet 13 allows the cold air from the vortex tube 7 to flow into the at least one closed heat exchanger channel 14. The heat exchanger channel being closed means that the only way air can enter the closed heat exchanger channel 14 is through the heat exchanger inlet 13, and the only way air can escape the closed heat exchanger cahnnel 14 is through a heat exchanger outlet 15. The closed heat exchanger channel 14 is preferably made from a material with high thermal conductivity, as is known in the art of heat exchangers.

The heat exchanger outlet 15 is connected to the outside of the cabinet 3, such that the air from the closed heat exchanger channel 14 is exhausted outside 6. The heat exchanger outlet 15 may be connected to the outside 6 either directly or by an outlet connection 17. The outlet connection 17 may be a rigid tube, a flexible hose, a valve, or any connection means for guiding air from the air-to-air heat exchanger 11 to the outside 6. The outlet connection 17 may preferably be isolated or made from a material with low heat conductivity, in order to minimize heat loss. The outlet connection 17 is optional, as the heat exchanger outlet 15 may be a part of the closed heat exchanger channel 14. The heat exchanger outlet 15 may also be arranged directly on the cabinet 3, or extend further away from the apparatus 2. If the heat exchanger outlet 15 is arranged on or in the vicinity of the cabinet 3, a heat brake may be provided between the heat exchanger outlet 15 and the cabinet 3.

The potentially contaminated, cold air passing through the closed heat exchanger channel 14 does not mix with the air on the inside 5 of the apparatus 2, and the optical and/or electronic elements 4 are thus prevented from contamination from the cold air. As the cold air flows through the closed heat exchanger channel 14, the air on the inside 5 of the apparatus 2 is cooled down, and the optical and/or electronic elements 4 are cooled down.

The heat exchanger inlet 13 is preferably located at one end of the closed heat exchanger channel 14, and the heat exchanger outlet 15 is preferably located at an opposite end of the closed heat exchanger channel 14. The heat exchanger outlet 15 may preferably be arranged below the heat exchanger inlet 13, as in the illustrated embodiment. If the closed heat exchanger channel 14 is oriented such that the heat exchanger outlet 15 is at or below the lowest point of the closed heat exchanger channel 14, the heat exchanger inlet 13 may preferably be at or above the highest point of the closed heat exchanger channel 14. Due to this arrangement of the outlet 15 below the inlet 13, impurities in the cold air from the vortex tube 7 is by gravity and the pressure of the cold air guided through the closed heat exchanger channel 14 and forced out through the heat exchanger outlet 15. Contamination from the air does thus not pose a risk for the efficiency or the functioning of the air-to-air heat exchanger 11. Oil contamination may not accumulate in the closed heat exchanger channel 14, and the air-to-air heat exchanger 11 provides a self-cleaning effect.

According to one embodiment, the closed heat exchanger channel is free or substantially free of any bend that in use directs the flow upwards, so as to avoid impurities getting stuck in the bends and build up in the closed heat exchanger channel. An alternative way of expressing that the closed heat exchanger channel is free of any bend directing the flow upwards, is that all bends in the channel is configured to direct the flow sideways or downwards. According to one embodiment the closed heat exchanger channel is straight or substantially straight, so as to prevent impurities from getting stuck in the closed heat exchanger channel.

The cooling device 1 in figure 1 comprises two fans 18. The two fans 18 may preferably be arranged on opposite sides of the closed heat exchanger channel 14, arranged to blow air towards the closed heat exchanger channel 14. This increases the efficiency of the air-to-air heat exchanger 11 by creating a flow of air past the closed heat exchanger channel 14. The cooling device 1 may as such comprise any number of fans 18. The fans 18 also create a flow of air throughout the inside 5 of the cabinet 3, ensuring optimal cooling of the optical and/or electronic elements 4.

In an alternative embodiment, the optical and/or electronic elements 4 may be provided directly on the air-to-air heat exchanger. The optical and/or electronic elements 4 may as such be provided on the heat exchanger channel, for direct cooling. Such a configuration may not require the presence of fans.

The cooling device 1 may be in addition to a separate and different cooling system of the apparatus 2. Such a separate and different cooling system may be a primary cooling system such as water chillers, back coolers, thermoelectric coolers, convection coolers and heat pumps that typically operates below 50°C ambient temperature. In general, the cooling device 1 may be configured to switch on if the temperature on either the inside 5 or the outside 6 of the cabinet 3 is above a predetermined temperature limit. The cooling device 1 may be a secondary cooling system for especially high temperatures, when a primary cooling system may not be sufficient to cool the optical and/or electronic elements 4. The cooling device 1 may comprise or be connected to a temperature sensor that triggers the cooling device 1 to turn on. The cooling device 1 may be triggered by the temperature of especially vulnerable optical and/or electronic elements 4. The cooling device 1 may be activated at a predetermined temperature threshold of e.g. 45, 50, 55, 60 or 65°C.

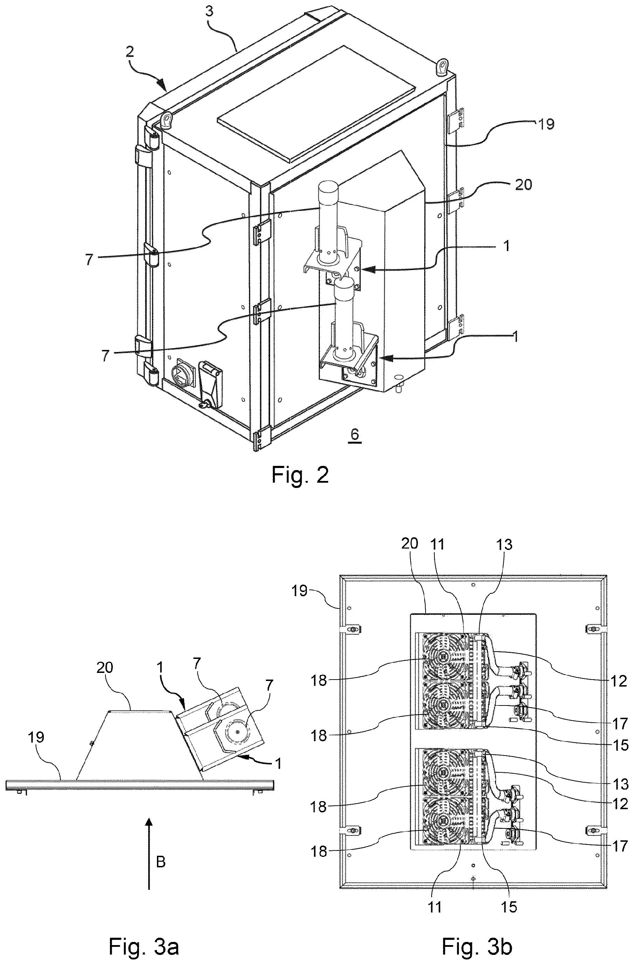

Referring now to figures 2, 3a and 3b. The figures show a first embodiment of two cooling devices 1 mounted on a apparatus 2. In this embodiment, a side wall of the cabinet 3 has been replaced with a wall panel 19 comprising the cooling devices 1.

The wall panel 19 may comprise a recess 20 that adds extra space to the interior of the apparatus 2. The air-to-air heat exchangers 11 may be arranged in the recess 20 of the wall panel 19. The recess 20 thus allows the cooling device 1 to be retrofitted to an apparatus 2 without occupying space from the previous interior of the apparatus 2. Figure 3a shows the wall panel 19 comprising the cooling devices 1 in isolation, as viewed from above, and figure 3b is a view along the arrow B in figure 3a. Figure 3b shows the inside of the wall panel 19 and recess 20.

Each cooling device 1 comprises a vortex tube 7. The vortex tubes 7 may be arranged on the outside of the recess 20, and the air-to-air heat exchangers 11 may be arranged on the opposite side of the wall panel 19, inside the recess 20. The cold air exhausted from the vortex tubes 7 is led through the wall panel 19 and into the air-to-air heat exchangers 11 through inlet connections 12 (not visible in figure 2, see figure 3b). The cold air flows through the heat exchanger inlets 13 into the closed heat exchanger channels of the air-to-air heat exchangers 11. The (warmer) air escapes the closed heat exchanger channels through the heat exchanger outlets 15, and is guided to the outside 6 by outlet connections 17. The air that has passed the closed heat exchanger channels are thus exhausted to the ambient air.

Each cooling device 1 of this embodiment comprises four fans 18. Two fans 18 are arranged in pairs on each side of the closed heat exchanger channel. As described with reference to figure 1, the cooling device 1 may be retrofitted or added in addition to a separate and different cooling system provided in the apparatus 2.

In another embodiment, the air-to-air heat exchanger may be housed in a generally closed housing, instead of a recess in a wall panel. A cooling device comprising an air-to-air heat exchanger within a housing may be placed and fixed almost anywhere on an apparatus, and may be especially suitable for cooling hot spots on an apparatus. Especially, the cooling device may preferably be placed on the outside of an apparatus, which would allow for easy retrofitting. A plurality of cooling devices may be placed on an apparatus. If there is no longer need for a coolig device, it may be easily removed from the apparatus. Such a cooling device may be a particular cheap and versatile option.

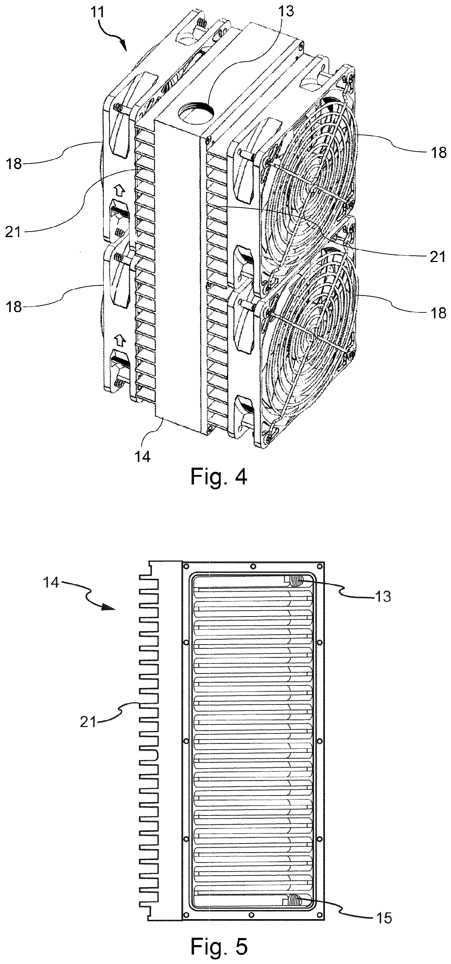

Figure 4 shows a first embodiment of an air-to-air heat exchanger 11. The air-to-air heat exchanger 11 may thus be a first embodiment of the air-to-air heat exchanger indicated inside the stapled box A in figure 1. The air-to-air heat exchanger 11 comprises a closed heat exchanger channel 14 and may comprise fans 18. The illustrated embodiment comprises four fans 18. Two fans 18 are provided on each side of the closed heat exchanger channel 14. The closed heat exchanger channel 14 may be housed within a generally rectangular cuboid as in the illustrated embodiment, such that the closed heat exchanger channel 14 may be sandwiched in between the fans 18.

The outside of the closed heat exchanger channel 14 may comprise one or more cooling ribs 21. The closed heat exchanger channel 14 may as such comprise a plurality of cooling ribs 21, distributed evenly around the closed heat exchanger channel 14, or at locations providing optimal cooling effect. Cooling ribs 21 increase the outer surface area of the closed heat exchanger channel 14, and thus increase the cooling capacity. The cooling ribs 21 may preferably be arranged on the two larger side surfaces of a generally flat, rectangular cuboid. The fans 18 blow hot air in between the cooling ribs 21, and the air is cooled. The air-to-air heat exchanger 11 comprises the heat exchanger inlet 13, in the illustrated embodiment simply an opening where cold air from a vortex tube can enter. A heat exchanger outlet (not visible in figure 4) is provided elsewhere on the air-to-air heat exchanger 11, as previously described preferably below, and on an opposite side of the heat exchanger inlet 13.

Figure 5 shows a first embodiment of a closed heat exchanger channel 14. The figure shows the inside of a closed heat exchanger channel 14. The closed heat exchanger channel 14 may preferably be formed between two corresponding halves, which, when mounted together, form the closed heat exchanger channel 14.

The closed heat exchanger channel 14 is in the illustrated embodiment shaped as a narrow channel extending in a zigzag pattern. In the first embodiment of the closed heat exchanger channel 14, there is only one channel through which all the air from the vortex tube have to pass. The closed heat exchanger channel 14 is illustrated with an heat exchanger inlet 13 at the top and a heat exchanger outlet 15 below. Cooling ribs 21 are also provided on the closed heat exchanger channel 14.

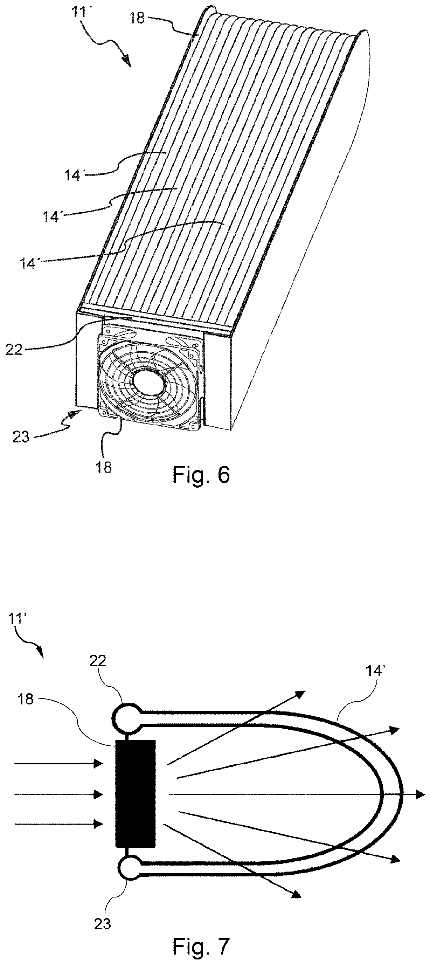

Figure 6 shows a second embodiment of an air-to-air heat exchanger 11', and figure 7 shows a schematic side view of the same. The air-to-air heat exchanger 11' may thus be a second embodiment of the air-to-air heat exchanger indicated inside the stapled box A in figure 1. In the second embodiment, the closed heat exchanger channel 14' comprises a plurality of tubes. The tubes may be made from materials with high thermal conductivity, such as copper.

Each closed heat exchanger channel 14' may preferably be generally U-shaped. The plurality of closed heat exchanger channels 14' may preferably also be arranged side-by-side. A U-shaped tube may comprise two legs that are parallel (shown in figure 7). The heat exchanger inlet (not shown) may be provided on an inlet manifold 22. The inlet manifold 22 may be a tube, a distribution channel or similar means for distributing the cold air from the vortex tube evenly to the plurality of closed heat exchanger channels 14'. The closed heat exchanger channels 14' may be connected to a corresponding outlet manifold 23 at the heat exchanger outlet (not shown). In this embodiment, the cold air is thus led from the vortex tube, into the inlet manifold 22, through the plurality of closed heat exchanger channels 14', into the outlet manifold 23, and exhausted through the heat exchanger outlet.

Also for the second embodiment, the heat exchanger outlet is preferably arranged below the heat exchanger inlet, such that impurities in the air from the vortex tube is transported through the closed heat exchanger channels 14' and blown out through the heat exchanger outlet by gravity and the pressure of the air flow.

At least one fan 18 may preferably be provided adjacent the inlet and outlet manifolds 22,23, for circulating air past the closed heat exchanger channels 14'. The fan 18 may be provided between the inlet and outlet manifolds 22,23, such that the closed heat exchanger channels 14' are exposed to the wind from the fan 18 entirely. The illustrated embodiment shows one fan 18, but a plurality of fans 18 may be provided in the air-to-air heat exchanger 11'. The fan 18 draws air from inside the apparatus, and blows it past the closed heat exchanger channels 14'. The closed heat exchanger channels 14' are preferably arranged such that there is an airgap between each closed heat exchanger channel 14', allowing a flow of air past each closed heat exchanger channels 14' to increase the cooling efficiency. Preferably, the air-to-air heat exchanger 11' may comprise sidewalls 24 provided at each distal closed heat exchanger channel 14'. The sidewalls 24 direct the air from the fan 18 along and towards the closed heat exchanger channels 14', and prevent the air from flowing anywhere but past the closed heat exchanger channels 14'.

Figure 7 shows how the air is blown through the fan 18 and past the closed heat exchanger channels 14'. Cold air from at least one vortex tube enters the inlet manifold 22 and flows through the closed heat exchanger channels 14'. The air from the fan 18 is cooled as it passes the closed heat exchanger channels 14'. The air passing through the plurality of closed heat exchanger channels 14' is collected in the outlet manifold 23, and is thereby exhausted through an outlet.

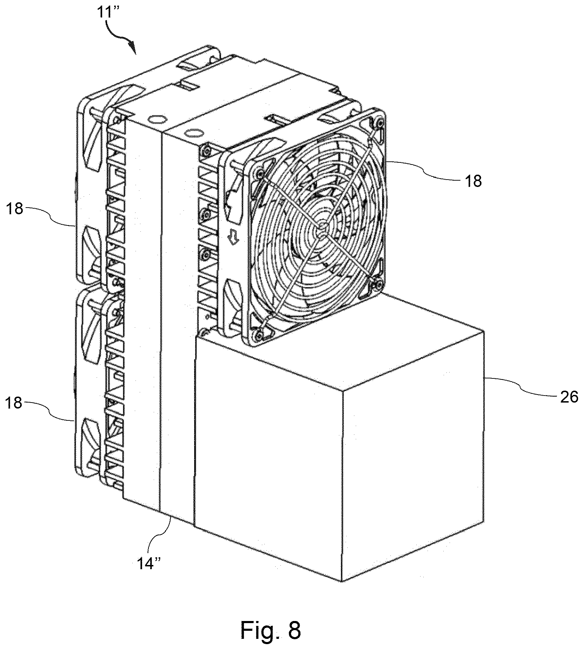

Figure 8 shows a third embodiment of an air-to-air heat exchanger 11". In this embodiment, optical and/or electronic elements are arranged adjacent the closed heat exchanger channel 14". The optical and/or electronic elements may be arranged directly on the closed heat exchanger channel 14", or they may be arranged in the proximate vicinity. The optical and/or electronic elements may also be placed inside an element housing 26, as in the illustrated embodiment. The element housing 26 may be fixed to or positioned adjacent the air-to-air heat exchanger 11". The element housing 26 may be made from a material with high thermal conductivity, or be thermally insulated, or a combination. A combination may comprise an element housing 26 comprising a side that is thermally conductive and provided to contact the closed heat exchanger channel 14", while one or more remaining sides of the element housing 26 are insulated.

The optical and/or electronic elements may be manufactured and designed to fit directly onto or be accommodated adjacent the closed heat exchanger channel 14", in order to maximize the cooling of the optical and/or electronic elements. The air-to-air heat exchanger 11" may additionally comprise fans 18 for increasing the cooling efficiency to the surroundings. The illustrated embodiment of the air-to-air heat exchanger 11" comprises three fans 18.

Additionally, variations to the disclosed variants can be understood and effected by the skilled person in practicing the claimed invention, from a study of the drawings, the disclosure, and the appended claims. In the claims, the word "comprising" does not exclude other elements, and the indefinite article "a" or "an" does not exclude a plurality. The mere fact that certain measures are recited in mutually different dependent claims does not indicate that a combination of these measured cannot be used to advantage.

## Claims

1. A cooling device (1) for optical and/or electronic elements (4) of an apparatus (2), comprising;
at least one vortex tube (7) for generating cold air,
at least one air-to-air heat exchanger (11; 11') comprising at least one closed heat exchanger channel (14; 14'),
the air-to-air heat exchanger (11; 11') further comprising a heat exchanger inlet (13) for receiving the cold air and guiding it into the at least one closed heat exchanger channel (11; 11'), and a heat exchanger outlet (15) for exhausting air from the at least one closed heat exchanger channel (14; 14').

2. The cooling device (1) according to claim 1, wherein, if the closed heat exchanger channel (14) is oriented such that the heat exchanger outlet (15) is at or below the lowest point of the closed heat exchanger channel (14; 14'), the heat exchanger inlet (13) is at or above the highest point of the closed heat exchanger channel (14; 14'), such that impurities and contaminations of the cold air is forced out through the outlet (15) due to gravity and the pressure of the cold air.

3. The cooling device (1) according to claim 1 or 2, wherein the at least one closed heat exchanger channel (14) comprises a plurality of cooling ribs (21) for increasing the outer surface area of the air-to-air heat exchanger (8).

4. The cooling device (1) according to claim 1 or 2, wherein the heat exchanger inlet (13) is provided on an inlet manifold (22) and the heat exchanger outlet (15) is provided on an outlet manifold (23) and the at least one closed heat exchanger channel (14') comprises a plurality of tubes for flowing the cold air from the inlet manifold (22) to the outlet manifold (23).

5. The cooling device (1) according to claim 4, wherein the plurality of tubes are U-shaped and arranged side-by-side with an airgap between each tube for allowing a flow of air past each tube to increase the cooling efficiency.

6. The cooling device (1) according to claim 4 or 5, wherein the inlet manifold (22) is provided at a first distal end of the plurality of closed heat exchanger channels (14') and the outlet manifold (23) is provided at a second distal end of the plurality of closed heat exchanger channels (14').

7. The cooling device (1) according to any one of the preceding claims, wherein the cooling device (1) further comprises at least one fan (12) for increasing the efficiency of the air-to-air heat exchanger (11; 11').

8. The cooling device (1) according to claim 7 when dependent on any one of claims 4-6, wherein the at least one fan (12) is provided adjacent the inlet manifold (22) and the outlet manifold (23), for circulating air past the plurality of closed heat exchanger channels (14').

9. The cooling device (1) according to any one of the previous claims, wherein a wall panel (19) is provided between the at least one vortex tube (7) and the at least one air-to-air heat exchanger (11; 11'), and an inlet connection (12) allows cold air from the at least one vortex tube (7) to flow through the wall panel (19) to the at least one air-to-air heat exchanger (11; 11').

10. The cooling device (1) according to claim 9, wherein the wall panel (19) comprises a recess (20) for accommodating the at least one air-to-air heat exchanger (11: 11').

11. An apparatus (2) comprising optical and/or electronic elements (4) housed in a cabinet (3), and at least one cooling device (1) according to any one of claims 1-10 for cooling the optical and/or electric elements (4), wherein the air-to-air heat exchanger (11; 11') of the at least one cooling device (1) is arranged inside (5) the cabinet (3) and the heat exchanger outlet (15) is arranged to exhaust air from the at least one closed heat exchanger channel (14; 14') to the outside (6) of the cabinet (3).

12. The apparatus (2) according to claim 11, wherein the vortex tube hot end (9) of the at least one vortex tube (7) is arranged on the outside (6) of the cabinet (3).

13. The apparatus (2) according to claim 11 or 12, wherein the at least one vortex tube (7) is arranged on the outside (6) of the cabinet (3) and connected to a device for providing pressurized air.

14. The apparatus (2) according to any one of claims 11-13, wherein the apparatus (2) is a vision sorting apparatus and the optical and/or electric elements (4) preferably comprises a machine vision system and/or an imaging spectroscopy system.

15. The apparatus (2) according to any one of claims 11-14, wherein the apparatus (2) additionally comprises a primary cooling system and the at least one cooling device (1) is activated at a predetermined temperature threshold.
